# FASCICULE DE BREVET EUROPEEN

(11) **EP 0 643 310 B1**
(45) Date de publication et mention de la délivrance du brevet: **07.11.2001**
(21) Numéro de dépôt: 94402020.5
(22) Date de dépôt: 09.09.1994
(51) Int. Cl.: G01R 31/36

(54) **Dispositif de contrôle de la décharge d'une pluralité de batteries montées en série**
Einrichtung zur Überwachung der Entladung einer Vielzahl in Reihe geschalteter Batterien
Device for monitoring the discharge of a plurality of series connected batteries

(30) Priorité: 09.09.1993 FR 9310708
(43) Date de publication de la demande: 15.03.1995
(73) Titulaire: REGIE NATIONALE DES USINES RENAULT S.A., 92109 Boulogne Billancourt (FR)
(72) Inventeur: Richer, Didier, F-92000 Nanterre (FR)

(56) Documents cités:
- EP-A- 0 112 242
- EP-A- 0 277 321
- EP-A- 0 432 639
- WO-A-88/04776
- WO-A-93/10466
- WO-A-93/10590
- US-A- 5 136 246
- RESEARCH DISCLOSURE, vol.344, no.37, Décembre 1992, GB pages 929 - 930 'A Voltage Monitoring System ... Multi-Cell Battery Packs ...'
- INTELEC '91 PROCEEDINGS, Novembre 1991, JP pages 177 - 180 Z.NOWOROLSKI 'A Microcomputer-Based Battery Management System'

## Description

La présente invention concerne un dispositif de contrôle de la décharge d'une pluralité de batteries montées en série.

L'invention concerne plus particulièrement un dispositif qui permet de prévenir une décharge profonde d'une batterie d'un ensemble de batteries montées en série en activant des moyens de signalisation lorsque un état prédéterminé de décharge est atteint par l'une au moins des batteries.

La publication FR-A-2.112.467 décrit un dispositif de signalisation de l'insuffisance de la tension présente aux bornes d'une batterie, lequel délivre un signal dès que la tension de la batterie descend en dessous d'un seuil préétabli.

Un tel dispositif monté aux bornes d'un ensemble de batteries en série présente cependant l'inconvénient de ne fournir qu'une indication globale sur l'état de décharge global de cet ensemble, sans indiquer le niveau de décharge individuel de chaque batterie.

En particulier, l'une des batteries peut déjà être profondément déchargée alors même que la valeur de la tension aux bornes de l'ensemble indique un état global de charge satisfaisant.

Le document EP 0 112 242 divulgue un dispositif de contrôle de la mesure de la capacité d'un ensemble de batteries. Chaque batterie de l'ensemble de batteries est adressée de façon cyclique par des moyens séquenceurs, qui délivrent alors un signal de mesure unique représentatif de la tension aux bornes de la batterie adressée. Ce signal est alors comparé à une tension de seuil correspondant à la fin de décharge de la batterie et un signal de sortie est émis lorsque la tension représentée par le signal de mesure est inférieure à la tension de référence.

L'objet de la présente invention est donc de pallier aux inconvénients de l'art antérieur en proposant un dispositif permettant de contrôler la décharge individuelle d'une pluralité de batteries montées en série. Les performances d'un ensemble de batteries montées en série sont en effet limitées par la batterie la moins chargée de cet ensemble. Le dépassement d'un seuil de décharge présélectionné par l'une des batteries informera donc le conducteur de l'état réel de l'ensemble des batteries.

Selon l'invention, le dispositif est caractérisé en ce qu'il comprend une pluralité de modules individuels identiques respectivement montés en parallèle aux bornes de chacune des batteries et en ce que chaque module possède :
- Une source de tension de référence,
- Un moyen de traitement relié d'une part respectivement aux bornes de la batterie et d'autre part à un premier conducteur de liaison d'une unité centrale à l'ensemble des modules montés en série,
- Un moyen comparateur relié d'une part au générateur et d'autre part au moyen de traitement,
- Un interrupteur asservi à la sortie du moyen comparateur,
et en ce que ledit module commande des moyens d'alerte d'un seuil de décharge de la batterie aux bornes de laquelle il est monté.

Selon une caractéristique de la présente invention, le seuil de décharge est réglé par un signal de commande généré par l'unité centrale et transmis simultanément à l'ensemble des modules par le premier conducteur de liaison.

Selon une autre caractéristique de la présente invention, le moyen de traitement est constitué par un photocoupleur associé à un circuit RC.

Avantageusement, l'interrupteur est constitué par un transistor MOSFET associé à une diode.

On comprendra mieux les buts, aspects et caractéristiques de la présente invention, d'après la description donnée ci-après d'un mode de réalisation de l'invention, présenté à titre d'exemple non limitatif, en se référant aux dessins annexés, dans lesquels :
- la figure 1 est une représentation schématique d'une installation mettant en oeuvre le dispositif suivant la présente invention,
- la figure 2 est une représentation schématique du synoptique fonctionnel correspondant à un module du dispositif conforme à l'invention,
- la figure 3 est un schéma fonctionnel de l'unité centrale du dispositif suivant l'invention,
- la figure 4 est un exemple de réalisation des moyens d'alerte représenté à la figure 1,
- la figure 5 est un exemple de réalisation du circuit électronique constitutif d'un module,
- les figures 6a et 6b représentent l'évolution du signal V_{c} délivré en sortie du moyen de traitement en fonction du temps pour différentes valeurs de composants électroniques dudit moyen de traitement.

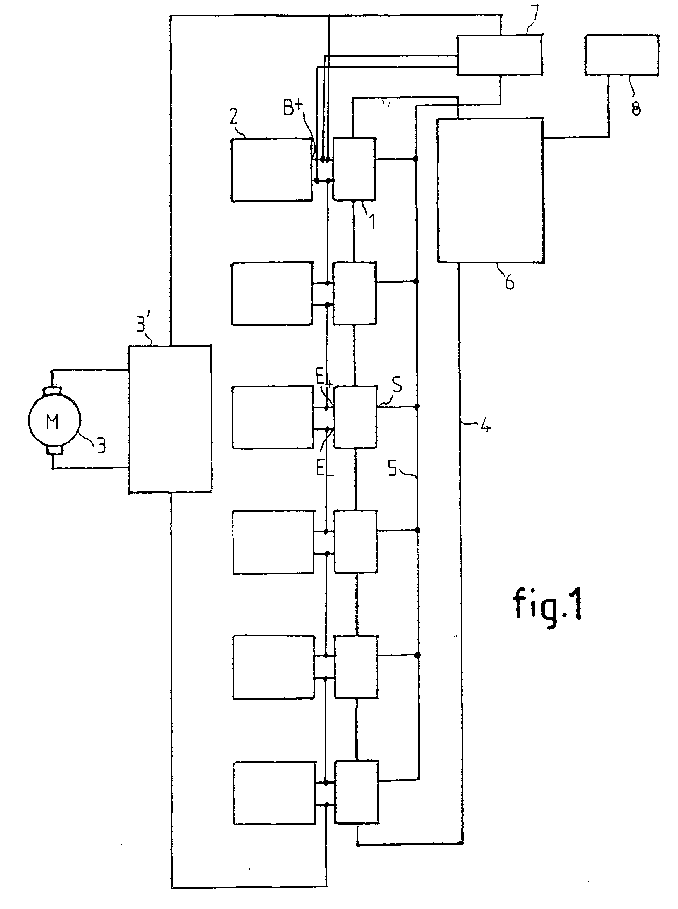

Conformément aux figures 1 à 5, seules les parties constitutives nécessaires à la compréhension de l'invention ont été représentées.

En référence à la figure 1, l'alimentation du moteur électrique 3 est assurée par une pluralité de batteries 2 montées en série par l'intermédiaire d'un variateur 3'. L'utilisation d'une pluralité de batteries en série pour la propulsion d'un véhicule électrique est rendue nécessaire du fait de la faible valeur, de l'ordre d'une dizaine de Volt, de la tension aux bornes d'une batterie seule. Or, les moteurs électriques équipant un véhicule automobile nécessitent une tension d'alimentation de l'ordre de la centaine de Volt. De plus, pour une même puissance absorbée par le moteur, les pertes par effet Joule dans les conducteurs décroissent avec l'augmentation de la tension de la source d'alimentation. Les batteries présentent de préférence des caractéristiques identiques.

Aux bornes de chaque batterie 2 sont connectées respectivement les entrées E⁺ et E⁻ d'un et d'un seul module 1.

Un premier conducteur de liaison 4 relie en série l'unité centrale 6 et les modules 1 entre eux.

Un second conducteur de liaison 5 relie en parallèle les moyens d'alerte 7 et les modules 1 entre eux.

Chaque module 1 s'autoalimente sur la batterie 2 qu'il contrôle, mais ne consomme cependant qu'un courant négligeable comparativement à l'autodécharge de ladite batterie.

Les moyens d'alerte 7 sont reliés d'une part à la borne positive B⁺ de l'ensemble des batteries 2 montées en série et d'autre part à la sortie S de chaque module 1 par l'intermédiaire du second conducteur de liaison 5.

Des moyens de sélection 8 sont reliés à l'unité centrale 6. Les moyens de sélection, qui peuvent être constitués par un clavier numérique disposé sur le tableau de bord et relié à l'unité centrale. Ces moyens de sélection 8 permettent au conducteur ou à un calculateur, préalablement préprogrammé, de choisir le seuil de décharge des batteries à partir duquel les moyens d'alerte 7 seront activés afin de prendre des mesures appropriées. Ces mesures peuvent être diverses suivant le seuil de décharge de la batterie sélectionné, ainsi un seuil de décharge de la batterie de 100% nécessite une recharge immédiate des batteries si l'on ne veut pas détériorer celle-ci alors qu'un seuil de décharge sélectionné de 80% nécessitera seulement une réduction de la vitesse du véhicule pour ménager la charge résiduelle de la batterie.

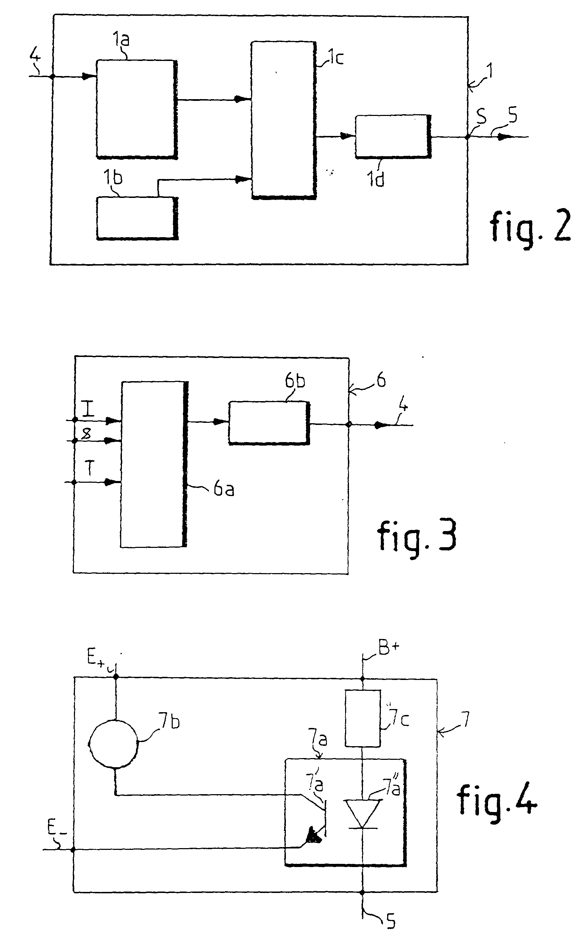

En référence à la figure 3, l'unité centrale 6 comprend des moyens de combinaison 6a qui transforment la valeur du seuil de décharge affiché à l'aide des moyens de sélection en un seuil de tension. La force électromotrice d'une batterie est en effet dans une certaine mesure représentative de la charge électrique résiduelle contenue dans celle-ci. Les moyens de combinaison reçoivent en entrée des signaux I, T et s représentatifs à chaque instant respectivement du courant débité par l'ensemble des batteries, de la température ambiante et de la valeur du seuil de décharge choisi. Ces signaux sont délivrés par des capteurs connus par ailleurs et non représentés.

Le seuil de tension correspondant au seuil de décharge choisi à l'aide des moyens de sélection 7 est déterminé par les moyens de combinaison 6a.

La charge résiduelle Qᵣₑₛ contenue dans une batterie à un instant donné et donc le seuil de décharge de celle-ci par rapport à un état de charge nominal, peut en effet être estimée selon une méthode connue qui consiste à intégrer par rapport au temps le courant I délivré par cette dernière, entre un instant où la charge de cette dernière est connue et l'instant t auquel on désire connaître la charge résiduelle Qᵣₑₛ. Néanmoins cette méthode ne s'applique que dans des conditions, de température notamment, constantes au cours de la mesure. La charge d'une batterie fluctue en effet avec la température ambiante du milieu dans lequel elle baigne. Des tables effectuant la correspondance entre la charge Q contenue dans une batterie étalon présentant à ses bornes la tension V à différentes températures T ont préalablement été mémorisées dans les moyens de conversion de l'unité centrale ie une fonction de la forme Qᵣₑₛ=f(T,V).

Des moyens de conversion 6b implantés dans l'unité centrale reçoivent en entrée le signal délivré par les moyens de combinaison et transforment ce dernier en un signal de commande généré sous la forme d'un signal périodique modulé en largeur d'impulsion : le signal de commande comprend un niveau d'amplitude A' et de durée a*T suivi d'un niveau d'amplitude nulle de durée (a-1)*T. Le paramètre a, compris entre 0 et 1, est déterminé en fonction du seuil de décharge sélectionné à l'aide des moyens de sélection.

En référence à la figure 2, chaque module 1 comporte des moyens comparateurs 1c reliés d'une part à une source de tension de référence 1b et d'autre part à un moyen de traitement 1a. Selon un mode de réalisation de la présente invention, la source de tension de référence est constituée par une diode Zéner Z1 reliée en série avec une résistance R1.

Un interrupteur 1d asservi à la sortie du moyen comparateur 1c est relié à la sortie S du module 1. Selon l'invention, l'interrupteur 1d est constitué per une diode D2 reliée en série avec un transistor MOSFET T2.

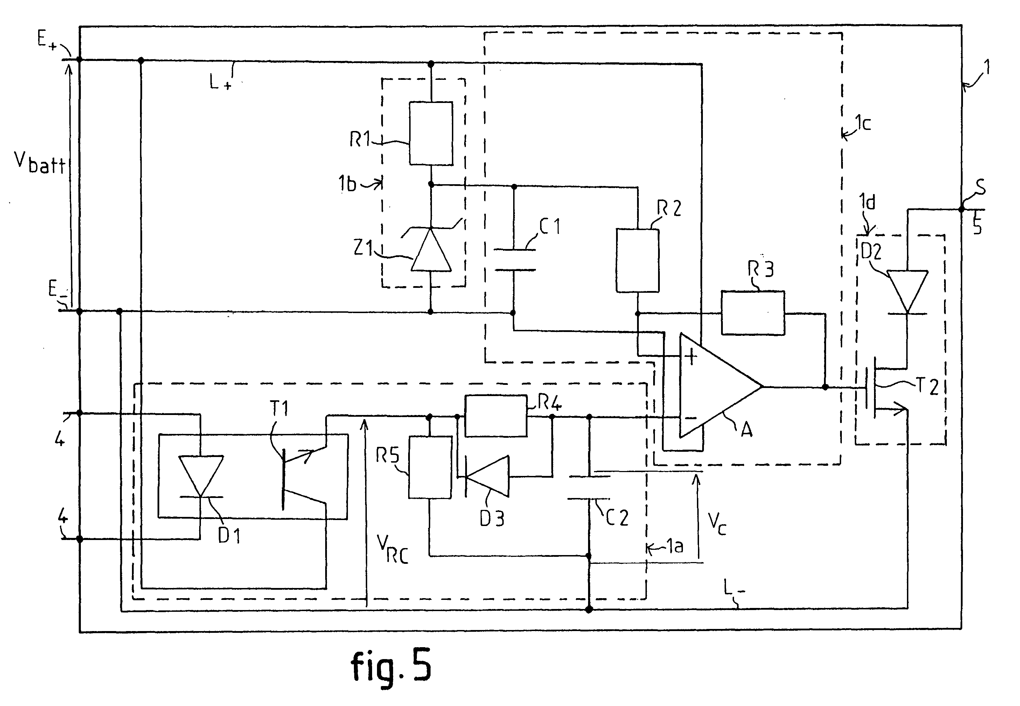

En référence à la figure 5, chaque module 1 comprend une ligne d'alimentation L+ reliée à l'entrée E⁺ du module et une ligne d'alimentation L- reliée à l'entrée E⁻.

Une résistance R1 est montée en série avec une diode Zéner Z1. Un condensateur C1 est monté entre la ligne L- et le point commun entre la résistance R1 et la diode Z1.

Une résistance R2 est montée entre le point commun entre la diode Z1 et la résistance R1 et l'entrée non-inverseuse d'un comparateur A. Une résistance R3 est montée entre l'entrée non-inverseuse et la sortie du comparateur A.

La borne positive d'alimentation du comparateur A est reliée au la ligne L-. La borne négative d'alimentation du comparateur est reliée à la ligne L-.

L'entrée inverseuse du comparateur A est reliée au point commun entre une résistance R4 et un condensateur C2, l'autre borne du condensateur C2 est reliée la ligne L-. Une résistance R5 est montée en parallèle aux bornes de l'ensemble constitué par la résistance R4 et le condensateur C2. Une diode D3 est montée en parallèle aux bornes de la résistance R4. Selon l'invention, le moyen de traitement 1a comprend un optocoupleur associé à un circuit RC. L'optocoupleur se compose de manière connue d'une diode électroluminescente D1 disposée en vis-à-vis avec un optotransistor T1.

Les optocoupleurs de chaque module 1 sont reliés en série par l'intermédiaire du premier conducteur de liaison 4. Un filtre passe-bas de type RC, composé des éléments R5, R4, D3 et C2 dont l'agencement entre eux a été précédemment décrit, est monté entre l'émetteur de l'optotransistor T1 et l'entrée inverseuse du comparateur A. La cathode de la diode est reliée à l'émetteur de l'optotransistor. Le collecteur de l'optotransistor est relié à la ligne L+.

L'interrupteur 1d est asservi à la sortie du comparateur A et se compose d'une diode D2 reliée par sa cathode au drain du transistor T2 et par son anode à la sortie S du module.

La source du transistor T2 est reliée à la ligne d'alimentation L-. La sortie du comparateur A est reliée à la grille d'un transistor MOSFET T2.

Conformément aux figures 1 à 5 et à la description précédente, le fonctionnement du dispositif est le suivant.

Dans le texte qui va suivre, sans mention expresse contraire, la tension en un point d'un module 1 sera mesurée par rapport à la ligne L- dudit module.

Lorsque les batteries 2 présentant un état de charge supérieur au seuil de décharge sélectionné, la valeur de la tension présente sur le fil d'émission 5 est égale à la valeur de la tension mesurée entre les bornes de l'ensemble de la pluralité des batteries. Au cours du roulage du véhicule, les batteries se déchargent graduellement, ce qui induit une chute de tension aux bornes de celles-ci.

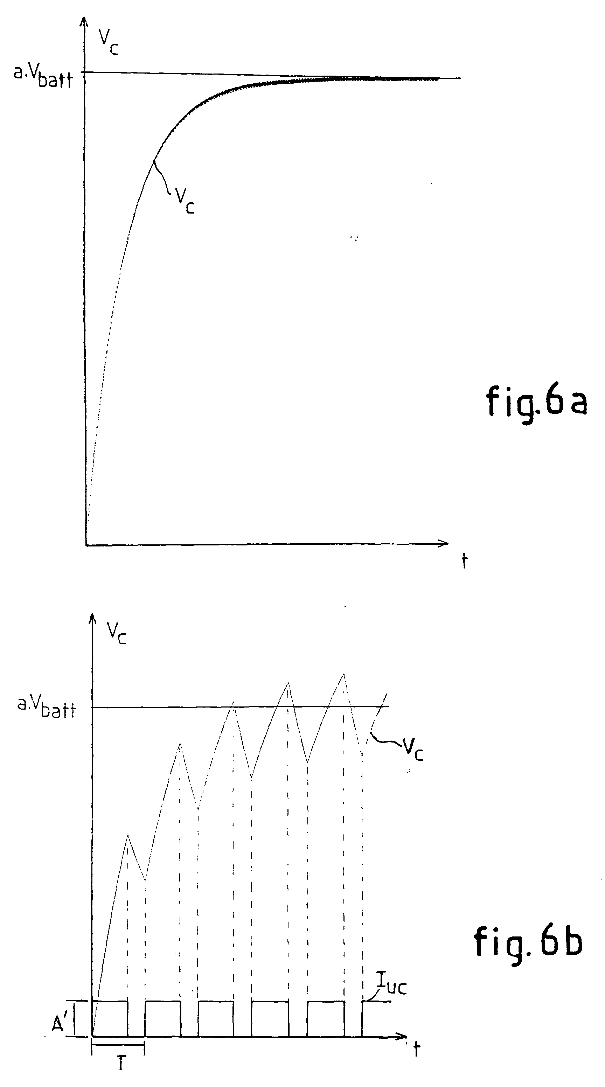

En régime établi, la tension V_{c} aux bornes du condensateur C2 est égale à la valeur moyenne de la tension V_{RC} appliquée à l'entrée du circuit RC. Cette valeur est égale à a*V_{batt} compte tenu de la forme du signal de commande I_{uc}, généré par l'unité centrale. le régime établi est réalisé au bout de quelques cycles successifs de charge et de décharge du condensateur à travers respectivement la résistance de charge R5 et la résistance de décharge R4. La résistance de charge est court-circuitée pendant la phase de décharge du condensateur à travers la résistance R4. La figure 6a représente l'évolution de la tension V_{c} en fonction du temps pour les valeurs suivantes : f= 1/T= 200 Hz, R4=R5=10⁺⁵ ohm et C2= 4,7.10⁻⁶ F. Ces valeurs correspondent à celles réellement utilisées par le dispositif selon l'invention et conduisent à une ondulation inférieure à 100 mV.

La figure 6b représente l'évolution de la tension V_{C} en fonction du temps et du signal modulé en largeur d'impulsion pour les valeurs suivantes : f=1/T = 20Hz, R4=R5=10⁺⁵ Ohm et C2=10⁻⁶ F, ces dernières étant choisies pour faciliter la représentation des cycles de charge et de décharge du condensateur C2 et faciliter la compréhension du fonctionnement du dispositif selon l'invention.

Le moyen comparateur A effectue la comparaison entre la tension de référence Vref appliquée à son entrée non-inverseuse et la tension a*V_{batt}, ce qui revient donc à comparer la tension V_{batt} au rapport V_{ref}/a. De manière connue avec un tel comparateur, lorsque la tension appliquée à son entrée non-inverseuse est supérieure à la tension appliquée à son entrée inverseuse, la tension en sortie de ce dernier correspond à la tension présente sur la borne positive d'alimentation du comparateur. Inversement, lorsque la tension appliquée à l'entrée non-inverseuse est inférieure à la tension appliquée à l'entrée inverseuse, la tension de sortie correspond à la tension présente sur la borne négative d'alimentation du comparateur.

Tant qu'aucune des batteries n'a atteint le seuil de décharge sélectionné, le fil d'émission 5 est en haute impédance et la diode 7"a de l'optocoupleur des moyens d'alerte 7 est bloquée, le voyant de signalisation 7b est donc éteint. Par contre, lorsque l'une au moins des batteries atteint le seuil de décharge sélectionné, le basculement de la sortie des moyens comparateurs provoque le passage du transistor MOSFET T2 de l'état bloqué à l'état passant. Le potentiel présent sur l'entrée E⁻ du module est reporté sur le fil d'émission 5. Un courant circule donc sur le fil d'émission, la diode 7"a devient passante ce qui provoque l'allumage du voyant 7b.

Le dispositif proposé permet donc de détecter simplement un seuil de décharge d'au moins une batterie d'un ensemble de batteries montées en série. Ce seuil de décharge est sélectionné par le conducteur. Le dispositif peut être utilisé pour contrôler des batteries de tous types.

De plus, chaque module s'autoalimente sur la batterie qu'il contrôle sans pénaliser cependant la charge de celle-ci car ne consommant qu'un courant négligeable comparativement à l'autodécharge de cette dernière.

## Revendications

1. Dispositif de contrôle de la décharge d'une pluralité de batteries montées comprenant une pluralité de modules (1) individuels identiques respectivement montés en parallèle aux bornes de chacune des batteries (2) et en ce que chaque module (1) possède :
- Une source de tension de référence (1b),
- Un moyen de traitement (la) relié d'une part respectivement aux bornes (E⁺,E⁻) de la batterie (2) et d'autre part à un premier conducteur de liaison (4) d'une unité centrale (6) à l'ensemble des modules (1) montés en série,
- Un moyen comparateur (1c) relié d'une part à la source (1b) et d'autre part au moyen de traitement (1a),
- Un interrupteur (1d) asservi à la sortie du moyen comparateur (1c),
et en ce que ledit module (1) commande des moyens d'alerte (7) d'un seuil de décharge de la batterie aux bornes de laquelle il est montée.

2. Dispositif selon la revendication 1 **caractérisé en ce que** le seuil de décharge est réglé par un signal de commande généré par l'unité centrale (6) et transmis simultanément à l'ensemble des modules (1) par le premier conducteur de liaison (4).

3. Dispositif selon la revendication 1 **caractérisé en ce que** le moyen de traitement (1a) est constitué par un photocoupleur associé à un circuit RC.

4. Dispositif selon la revendication 1 **caractérisé en ce que** l'interrupteur (1d) est constitué par un transistor MOSFET (T2) associé à une diode (D2).

## Patentansprüche

1. Vorrichtung zur Kontrolle der Entladung einer Mehrzahl von miteinander verbundenen Batterien, die eine Mehrzahl von identischen einzelnen Modulen (1) umfaßt, die jeweils an den Klemmen jeder der Batterien (2) parallel geschaltet sind, wobei jedes Modul (1) aufweist:
- eine Bezugsspannungsquelle (1b),
- ein Verarbeitungsmittel (1a), das einerseits jeweils mit den Klemmen (E⁺, E⁻) der Batterie (2) und andererseits mit einer ersten Leitung (4) zur Verbindung einer Zentraleinheit (6) mit der Gruppe der in Reihe geschalteten Module (1) verbunden ist,
- ein Vergleichsmittel (1c), das einerseits mit der Quelle (1b) und andererseits mit dem Verarbeitungsmittel (1a) verbunden ist,
- einen gesteuerten Unterbrecher (1d) am Ausgang des Vergleichsmittels (1c),
und wobei das Modul (1) Alarmmittel (7) für eine Entladungsschwelle der Batterie, an deren Klemmen er geschaltet ist, steuert.

2. Vorrichtung nach Anspruch 1, **dadurch gekennzeichnet, daß** die Entladungsschwelle von einem Steuersignal eingestellt wird, das von der Signaleinheit (6) erzeugt und über die erste Verbindungsleitung (4) gleichzeitig zur Gesamtheit der Module (1) übertragen wird.

3. Vorrichtung nach Anspruch 1, **dadurch gekennzeichnet, daß** das Verarbeitungsmittel (1a) aus einem Optokoppler besteht, der mit einem RC-Glied verbunden ist.

4. Vorrichtung nach Anspruch 1, **dadurch gekennzeichnet, daß** der Unterbrecher (1d) aus einem MOSFET-Transistor (T2) besteht, der mit einer Diode (D2) verbunden ist.

## Claims

1. Device for monitoring the discharge of a plurality of mounted batteries comprising a plurality of identical individual modules (1) respectively mounted in parallel to the terminals of each of the batteries (2), and in that each module (1) is provided with:
- a reference voltage supply (1b),
- a processing means (1a) connected on the one hand respectively to the terminals (E⁺, E⁻) of the battery (2) and on the other hand to a first connecting conductor (4) of a central unit (6) to the assembly of modules (1) mounted in series,
- a comparator (1c) connected on the one hand to the supply (1b) and on the other hand to the processing means (1a),
- a switch (1d) controlled at the output of the comparator (1c),
and in that said module (1) controls alarm means (7) for a discharge threshold of the battery on the terminals of which it is mounted.

2. Device according to claim 1, **characterised in that** the discharge threshold is adjusted by a control signal generated by the central unit (6) and transmitted simultaneously to the assembly of modules (1) by the first connecting conductor (4).

3. Device according to claim 1, **characterised in that** the processing means (1a) is constituted by an optical coupler connected to an RC circuit.

4. Device according to claim 1, **characterised in that** the switch (1d) is constituted by a MOSFET transistor (T2) connected to a diode (D2).
